# EUROPEAN PATENT APPLICATION

(11) **EP 4 704 086 A1**
(43) Date of publication of application: **04.03.2026**
(21) Application number: 25172374.8
(22) Date of filing: 24.04.2025
(51) Int. Cl.: G11C 29/02, G11C 29/12, G11C 7/10

(54) **A CIRCUIT FOR PERFORMING ANALOG CALIBRATION FOR A SCALABLE MULTI-VOLTAGE MEMORY INTERFACE DRIVER**

(30) Priority: 03.09.2024 IN 202441066561
(71) Applicant: Samsung Electronics Co., Ltd., Suwon-si, Gyeonggi-do 16677 (KR)
(72) Inventor: VENKATANARAYANAN, Hari Vijay, 560048 Bengaluru (IN); BATTINI, Ergam Reddy, 560048 Bengaluru (IN); ALAMURU, Maheswara, 560048 Bengaluru (IN); SAHU, Rustum Prasad, 560048 Bengaluru (IN)
(74) Representative: Marks & Clerk LLP

(57) **Abstract**

A circuit for calibrating analog signals on a scalable memory interface driver is provided. The circuit includes: PMOS and NMOS drivers; a variable gate voltage generation circuit; a pull-up stop signal generation circuit; and a pull-down stop signal generation circuit. The circuit is configured to: provide a first variable voltage to the PMOS driver from the variable gate voltage generation circuit; stop the first variable voltage from changing by disconnecting a first current source according to using a pull-up calibration stop signal, based on identifying that the first driver output is greater than a reference value; provide a second variable voltage to the NMOS driver from the variable gate voltage generation circuit; and stop the second variable voltage from changing by disconnecting a second current source according to using a pull-down calibration stop signal, based on the second driver output from the NMOS driver being less than the reference value.

## Description

### BACKGROUND

### 1. Field

The present disclosure relates to calibrating a circuit for a scalable memory interface driver, and to using a scalable memory interface driver in a multiple memory interface protocol domain, by varying a gate voltage of a p-channel metal-oxide-semiconductor (PMOS) and an n-channel metal-oxide-semiconductor (NMOS) driver.

### 2. Description of Related Art

Transmitters used in memory interface drivers can employ various memory interface protocols (such as low power double data rate 5 (LPDDR5), double data rate 5 (DDR5), TOGGLE, and so on), which operate using different supply voltages. Therefore, multiple drivers having different designs and calibration schemes may be used across different protocols.

However, using multiple drivers can lead to a significant increase in design area, cost, and resources. Using a single driver structure will lead to issues such as, tripling design area due to increasing the number of driver legs, and so on.

In a related approach, a wide range of supply voltages may be supported by increasing the number of driver legs by almost three times, so that as the supply voltage changes, the required driver impedance can be set. Such a configuration leads to an increase in pad capacitance to 1.8 pF affecting the maximum data rate supported. Also, this configuration is limited by the devices used for a higher voltage domain which require a thick oxide to avoid stress, and for a lower voltage domain which requires thin oxide devices.

In another related approach, is to develop N different design IPs, to support N different protocols. However, this approach leads to an increase in the design area and the cost by N times.

Hence, there is a need in the art for solutions which will overcome the above-mentioned drawback(s), among others.

### SUMMARY

One or more example embodiments provide a circuit for performing analog calibration for a scalable multi-voltage memory interface driver.

One or more example embodiments provide a circuit for varying a gate voltage of a PMOS driver and an NMOS driver according to a set impedance.

One or more example embodiments provide methods and systems for providing a single scalable calibration scheme for a single driver structure that can be used for multiple memory interface protocol (multi-voltage) domain.

According to an aspect of an example embodiment, a circuit for calibrating analog signals on a scalable memory interface driver, includes: a p-channel metal-oxide semiconductor (PMOS) driver; an n-channel metal-oxide semiconductor (NMOS) driver; a variable gate voltage generation circuit; a pull-up stop signal generation circuit; and a pull-down stop signal generation circuit. The circuit is configured to: provide a first variable voltage to the PMOS driver from the variable gate voltage generation circuit, wherein a transistor of the PMOS driver is configured to receive a power supply voltage, and a first driver output of the PMOS driver is connected to an external resistor; stop the first variable voltage from changing by disconnecting a first current source according to using a pull-up calibration stop signal, based on identifying that the first driver output is greater than a reference value; provide a second variable voltage to the NMOS driver from the variable gate voltage generation circuit, wherein a second driver output from the NMOS driver is provided after the pull-up calibration stop signal is generated; and stop the second variable voltage from changing by disconnecting a second current source according to using a pull-down calibration stop signal, based on the second driver output from the NMOS driver being less than the reference value. The first driver output and the second driver output may be signals, e.g. voltages. The transistor of the PMOS driver may generate the first driver output. The PMOS driver may be connected to the external resistor. The output of the PMOS driver may be connected to the external resistor. The circuit may further comprise the external resistor. The resistor may be external to the PMOS driver. The variable gate voltage generation circuit may comprise the first and second current sources. The circuit may be configured to stop the second variable voltage from changing only after the first variable voltage has been stopped from changing.

At least some of the above and other features of the disclosure are set out in the claims.

### BRIEF DESCRIPTION OF DRAWINGS

The above and other aspects, features and advantages will be apparent from the following description, taken in conjunction with the accompanying drawings, in which:
FIG. 1 is a circuit diagram illustrating a driver structure that uses programmable legs controlled by a 5-bit process, voltage and temperature (PVT) code;
FIG. 2 is a circuit diagram for generating a PVT code for a given driver impedance in the range of 30-240 Ω;
FIG. 3 is a circuit diagram illustrating the occurrence of stress voltages in a p-channel metal-oxide semiconductor (PMOS) and n-channel metal-oxide semiconductor (NMOS) device;
FIG. 4 depicts a circuit for calibrating a circuit in a scalable memory interface driver used in multiple interface protocol, according to example embodiments;
FIG. 5 depicts a driver structure with fixed legs used in a calibration scheme, according to example embodiments;
FIG. 6 is a circuit diagram illustrating the usage of voltage generators in pre-driver structure, according to example embodiments;
FIG. 7 is a circuit diagram illustrating a programmable voltage generator used in pull-up and pull-down calibration schemes, according to example embodiments;
FIGs. 8 and 9 are circuit diagrams illustrating generating a pull-up calibration stop signal and generating a pull-down calibration stop signal respectively, according to example embodiments;
FIG. 10 is a graph diagram illustrating programmable voltage generation based on timing, according to example embodiments;
FIG. 11 is a graph diagram illustrating a pull up calibration stop signal based on timing, according to example embodiments; and
FIG. 12 is a graph diagram illustrating a pull-down calibration stop signal based on timing, according to example embodiments.

### DETAILED DESCRIPTION

Hereinafter, example embodiments will be described in detail with reference to the accompanying drawings. Embodiments described herein are example embodiments, and thus, the present disclosure is not limited thereto, and may be realized in various other forms. Each example embodiment provided in the following description is not excluded from being associated with one or more features of another example or another example embodiment also provided herein or not provided herein but consistent with the present disclosure. For example, even if matters described in a specific example or example embodiment are not described in a different example or example embodiment thereto, the matters may be understood as being related to or combined with the different example or example embodiment, unless otherwise mentioned in descriptions thereof. In addition, it should be understood that all descriptions of principles, aspects, examples, and example embodiments of the present disclosure are intended to encompass structural and functional equivalents thereof. In addition, these equivalents should be understood as including not only currently well-known equivalents, but also equivalents to be developed in the future, that is, all devices performing the same functions regardless of the structures thereof.

As used herein, the words/phrases "exemplary", "example", "illustration", "in an instance", "and the like", "and so on", "etc.", "etcetera", "e.g.," , "i.e.," are used herein to indicate an example, instance, or illustration. Any example embodiment or implementation described herein using the words/phrases "exemplary", "example", "illustration", "in an instance", "and the like", "and so on", "etc.", "etcetera", "e.g.,", "i.e.," is not necessarily to be construed as preferred or advantageous over other example embodiments.

Example embodiments herein may be described and illustrated in terms of blocks which carry out a described function or functions. These blocks, which may be referred to herein as managers, units, modules, hardware components or the like, are physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of may be physically separated into two or more interacting and discrete blocks without departing from the scope of the disclosure. Likewise, the blocks of may be physically combined into more complex blocks without departing from the scope of example embodiments.

It should be noted that elements in the drawings are illustrated for the purposes of this description and ease of understanding and may not have necessarily been drawn to scale. For example, the flowcharts/sequence diagrams illustrate the method in terms of the operations required for understanding of aspects of example embodiments. Furthermore, in terms of the construction of the device, one or more components of the device may have been represented in the drawings by symbols, and the drawings may show only those specific details that are pertinent to understanding example embodiments so as not to obscure the drawings with details that will be readily apparent to those of ordinary skill in the art having the benefit of the description herein. Furthermore, in terms of the system, one or more components/modules may be represented in the drawings by symbols, and the drawings may show only those specific details that are pertinent to understanding example embodiments so as not to obscure the drawings with details that will be readily apparent to those of ordinary skill in the art having the benefit of the description herein.

The accompanying drawings are used to help easily understand various technical features and it should be understood that specific example embodiments presented herein are not limited by the accompanying drawings. As such, disclosure should be construed to extend to any modifications, equivalents, and substitutes in addition to those which are particularly set out in the accompanying drawings and the corresponding description. Usage of words such as first, second, third etc., to describe components/elements/ operations/steps is for the purposes of this description and should not be construed as sequential ordering/placement/occurrence unless specified otherwise.

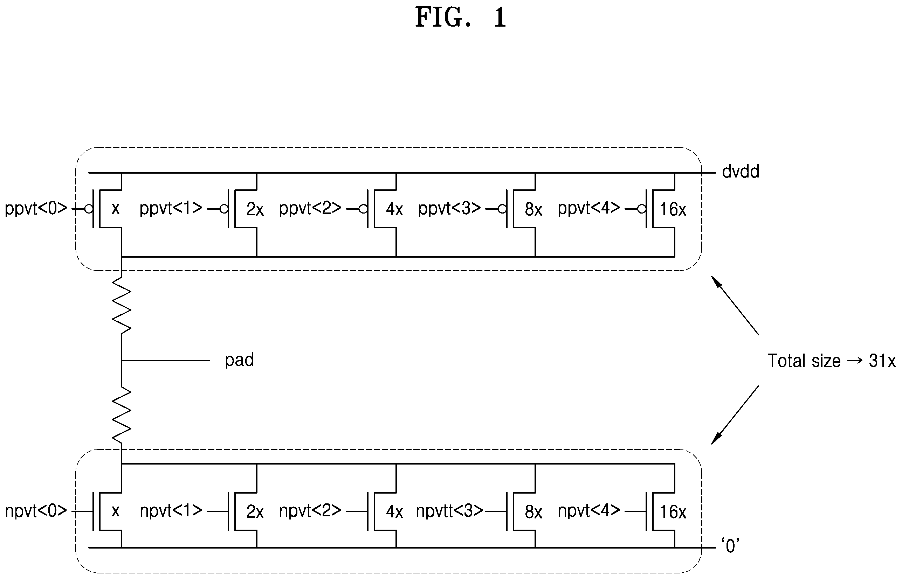

FIG. 1 is an example circuit diagram illustrating a driver structure that uses programmable legs controlled by a 5-bit process, voltage and temperature (PVT) code. Driver pull-up impedance and driver pull-down impedance should be fixed across all process, voltage and temperature (PVT) variations. To achieve a pull-up/pull-down impedance of 240Ω, 80% of 240Ω, that is 192Ω, may be obtained from passive resistance R, and the remaining 48Ω (20%) may be obtained from PMOS/NMOS devices. By having the majority of resistance come from the passive resistance R, the driver impedance will not significantly vary when pad voltage changes. However, both the passive resistor R and PMOS/NMOS device resistance varies with process, voltage and temperature (PVT). To address these issues, as shown in FIG. 1, the circuit includes a p-channel metal-oxide-semiconductor (PMOS) driver and an n-channel metal-oxide-semiconductor (NMOS) driver legs. A leg is a branch of PMOS/NMOS devices, and in FIG.1 there are five branches (legs) of PMOS/NMOS devices using five legs of binary weighted sizes of 1x, 2x, 4x, 8x and 16x, where 'x' is transistor width in µm. These five legs, for both pull-up and pull-down, may be selected based on 5-bit PVT code (ppvt<4:0>/npvt<4:0>). This PVT code for pull-up and pull-down driver is determined by the driver calibration circuit. For example, the calibrated PVT code for the pull up (ppvt) PMOS driver may be set to <4:0> and the calibrated PVT code for the pull-down-(npvt) NMOS driver may be set to <4:0>.

As illustrated in FIG.1, the related driver with the programmable legs occupies a total size of 31x with the PMOS and the NMOS driver. Moreover, the PVT code is needed to keep the driver impedance fixed as process, voltage and temperature changes.

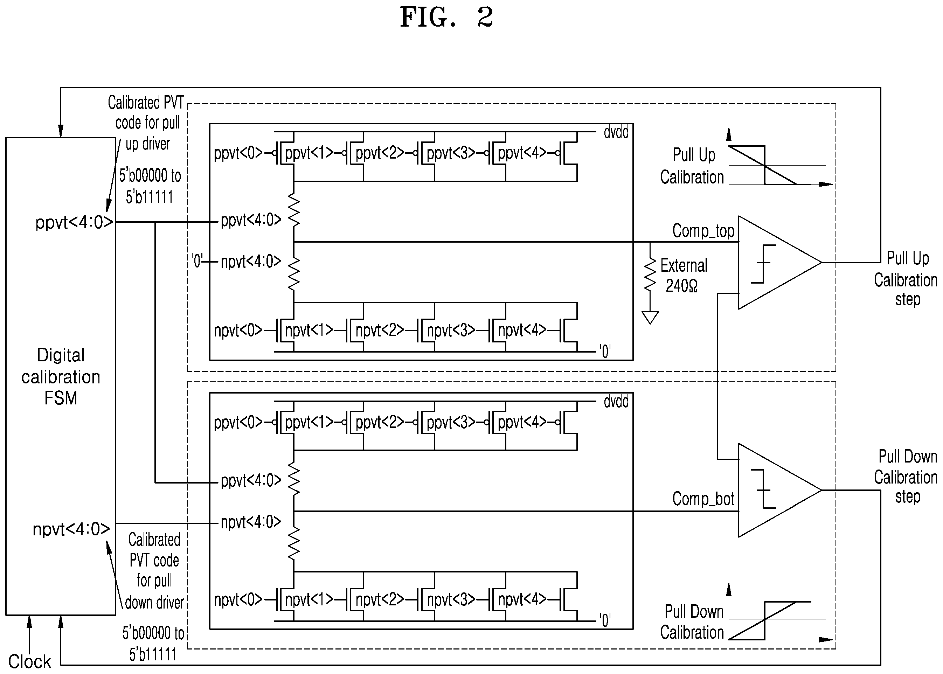

FIG. 2 is an example circuit diagram for generating a PVT code for a given driver impedance in the range of30-240 Ω. As illustrated in FIG. 2, the circuit includes a finite state machine (FSM) and an analog calibration scheme with the pull up calibration operation and the pull-down calibration operation. As illustrated in FIG. 2, the digital calibration FSM is configured for the analog calibration scheme with PMOS and NMOS drivers.

As illustrated in FIG. 2, the PMOS driver can be employed for the pull up calibration, in which the calibrated PVT code for pull up driver is applied. The calibrated PVT code (ppvt) for the pull up driver from 5'b00000 to 5'b11111 can be provided to the PMOS. As illustrated in FIG. 2, for performing the pull up calibration, the top driver output comp_top can be connected to an external resistor of 240 Ω. When performing the pull up calibration, the pull up PMOS devices can be enabled and pull down NMOS devices can be disabled. Therefore, the top driver output comp_top is compared with a reference value of 0.5* IO supply voltage (dvdd). The calibrated PVT code for the pull up driver ppvt<4:0> is varied, until the comp_out is less than 0.5*dvdd, accordingly. Hence, based on identifying that the comp_out is less than 0.5*dvdd, a comparator switches from one to zero, and the code may be locked.

As illustrated in FIG. 2, the NMOS driver can be employed for performing the pull-down calibration, in which the calibrated PVT code for the pull down driver is applied. The bottom driver (NMOS) can be employed, and the calibrated PVT code (npvt) for the pull-down driver from 5'b00000 to 5'b11111 can be provided to the NMOS. The npvt <4:0> code can be used to set the pull-down driver impedance to 240 Ω. Also, the 240 Ω pull up calibrated PMOS driver is used as a reference for the pull down NMOS driver.

As illustrated in FIG. 2, the bottom driver output comp_bot can be compared with the reference value of 0.5* IO supply voltage (dvdd). The calibrated PVT code for the pull-down driver npvt <4:0> is varied, until comp_bot is greater than 0.5*dvdd. Hence, based on identifying that comp_bot is greater than 0.5*dvdd, the comparator switches from zero to one, and the code is locked. Therefore, as illustrated in FIG. 2, the calibration scheme is configured to generate the PVT code for a given driver impedance, in the range of 30-240 Ω.

In a related calibration scheme and driver structure, as voltage changes, the calibration scheme has limitations such as the number of driver legs required, and the device stress. The number of driver legs will affect the driver output pad capacitance, wherein the pad capacitance directly affects the bandwidth. For example, when eight copies of the driver shown in FIG.1 are used to get 30 Ω (240 Ω/8), the pad capacitance is 600 fF. And, to support a wide voltage range (0.5V - 1.2V), the calibration scheme requires that the number of driver legs is to be tripled. As a result, the pad capacitance is increased to 1.8 pF.

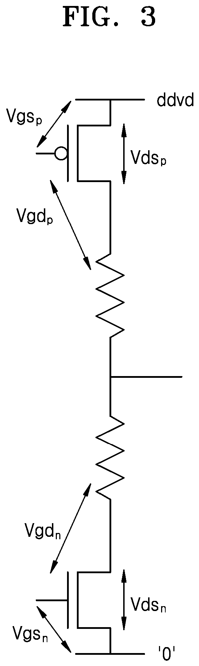

FIG. 3 is an example circuit diagram illustrating stress voltages in a PMOS and NMOS device. In the related mechanism, related to the device stress, the PMOS and NMOS devices in the driver structure can be configured with three voltages across source, drain and gate terminals (i.e., Vgsₚ, Vgdₚ and Vdsₚ for the PMOS devices, and Vgsₙ, Vgdₙ and Vdsₙ for the NMOS devices). As illustrated in FIG. 3, as voltage scales from 0.5 to 1.2V, stress voltage also changes, which in turn provides a constraint on the device type used. For higher input/output (IO) supply (1.05 V or 1.2 V), 'thick oxide' devices need to be used, that can sustain the stress of 1.05 V or 1.2 V. For a 0.5 V supply, a 'thin oxide' device can be used. As a result, a single driver structure cannot be used for multiple-protocols. Therefore, to support a wide voltage range (0.5 V to 1.2 V), the calibration scheme requires a combination driver, that includes a two-driver structure (a thin oxide driver and a thick oxide driver) which leads to increase in design area.

Example embodiments provide a circuit for calibrating analog signals on a scalable memory interface driver, using a p-channel metal-oxide semiconductor (PMOS) and an n-channel metal-oxide semiconductor (NMOS) driver.

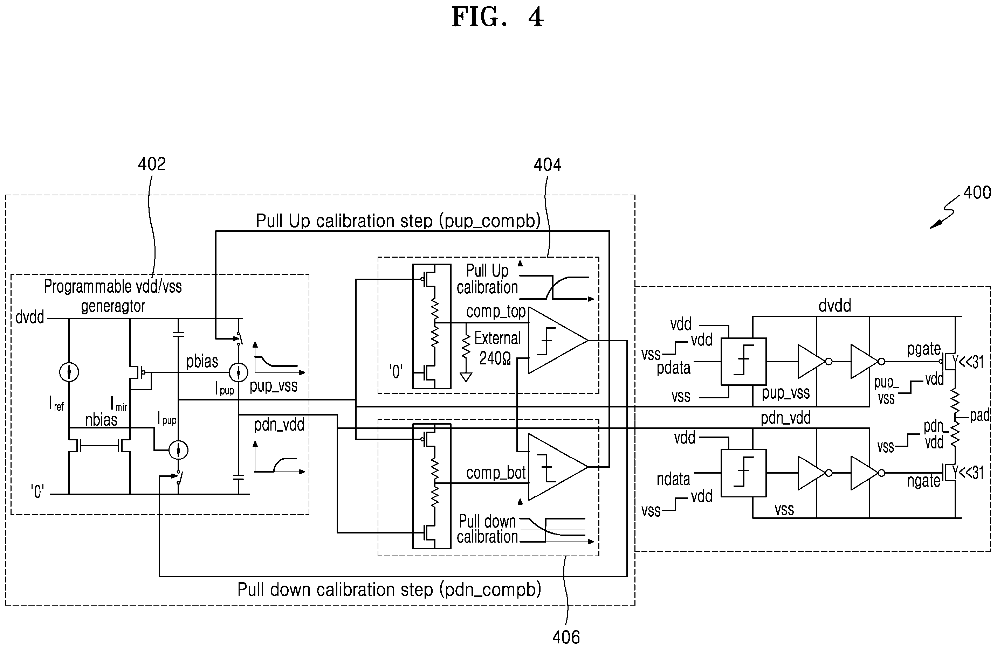

FIG. 4 depicts a circuit for calibrating a circuit in a scalable memory interface driver used in multiple interface protocol, according to example embodiments. Example embodiments provide a circuit 400 for calibrating the scalable memory interface by varying the gate voltage of a p-channel metal-oxide semiconductor (PMOS) driver and an n-channel metal-oxide semiconductor (NMOS) driver. The circuit 400 can be configured with a power supply to generate various voltages used for the pull-up and pull-down calibration schemes. By varying the gate voltage received to the circuit 400, a required resistance may be obtained, which can be used for multiple memory interface protocols having different voltages and domains.

The circuit 400 includes a variable gate voltage generation circuit 402, a pull-up stop signal generation circuit 404, and a pull-down stop signal generation circuit 406. The variable gate voltage generation circuit 402 can be provided with a supply voltage (Vdd) and a ground voltage (Vss). Vdd is the voltage applied to the source of PMOS transistor. Vdd is a positive power voltage. Vss is the voltage applied to a source of NMOS. Vss is less than Vdd, and may be a negative power voltage or connected to ground.

The circuit with the PMOS driver can be used for providing the pull-up calibration scheme and the NMOS driver for the pull-down calibration scheme. The variable gate voltage generation circuit 402 can be configured to generate a variable voltage. The first variable voltage (pup_vss) generated by the variable gate voltage generation circuit 402 can be provided to the PMOS driver. A transistor of the PMOS driver with a power supply, based on receiving the first variable voltage (pup_vss), generates a first driver output connected to an external resistor. The pull-up stop signal generation circuit 404, based on identifying that the generated first driver output is greater than a reference value (Vref), can generate a stop signal. The stop signal generated by the pull-up stop signal generation circuit 404 can be used to stop the receiving first variable voltage (pup_vss) (e.g., stop from changing) using a calibration stop signal. The reference value (Vref) is the reference voltage provided to a comparator.

In an example embodiment, the variable gate voltage generation circuit 402 can be configured to provide a second variable voltage (pdn_vdd) to the NMOS driver. The second driver output can be generated from the NMOS driver, after providing the pull up calibration which is connected to the PMOS driver.

The pull-down stop signal generation circuit 406, based on identifying that the second generated driver output from the NMOS driver is less than the reference value (Vref), can generate a stop signal. The generated stop signal can stop the receiving second variable voltage (e.g., stop from changing) using the pull-down calibration stop signal.

The variable gate voltage generation circuit 402 includes a current source, a switch, a current mirror, at least one metal-oxide-semiconductor (MOS) device, and at least one capacitor, wherein a gate voltage (as generated by the variable gate voltage generation circuit 402) can be based on tracking the supply voltage. Further, the lower supply and higher ground voltage generation paths can be formed by the current source from a bias generation circuit, and the current mirror from the MOS devices and the capacitor. For example, the variable gate voltage generation circuit 402 may stop changes in a variable voltage by controlling a switch corresponding to a current source.

For example, with reference to FIG. 3, Vgsₚ = |Vgₚ - Vsₚ|, Vgₚ is the gate voltage and Vsₚ is the supply voltage DVDD. The Vgsₚ voltage is required to provide a certain impedance from the PMOS device. For example, the Vgsₚ voltage may be determined through design simulation. To obtain the same impedance from PMOS device, even as the supply (Vsₚ) changes, the gate voltage Vgₚ, should also change similarly, so that the difference |Vgₚ - Vsₚ|, will remain the same. Thus, as shown in FIG. 4, the gate voltage of a PMOS device in the driver changes as the supply (DVDD) changes, and the difference |Vgₚ - Vsₚ| may be controlled to be the same through the programmable Vdd/Vss generator. For example, the programmable Vdd/Vss generator block Vgₚ is the gate voltage pup_vss, and Vsₚ is the supply DVDD.

As an example, the Vgsₚ required for the PMOS device to get a certain impedance may be 500mV (i.e., |Vgₚ-Vsₚ| =500mV). In this regard, if DVDD (Vsₚ) changes from 1.2V to 600mV, the programmable Vdd/Vss generator, will track this supply (Vsₚ) change, and accordingly change the Vgₚ (pup_vss) voltage from 700mV to 100mV, so that the difference |Vgₚ-Vsₚ| will always be equal to 500mV

For example, pup_vss (Vgₚ) may be initially charged to DVDD. The programmable Vdd/Vss generator will then start reducing pup_vss. For example 500mV may be the |Vgₚ-Vsₚ| required to get 240Ω. As soon as gate voltage pup_vss (Vgₚ) is equal to (DVDD- 500mV), the top driver impedance from (PMOS devices + passive resistor R), will be equal to 240Ω, which is the external ideal 240Ω resistor. At this point, comp_top will be equal to 0.5*dvdd and the comparator will switch from HIGH to LOW, and the programmable Vdd/Vss generator will stop reducing pup_vss. In other words, pup_vss will be locked.

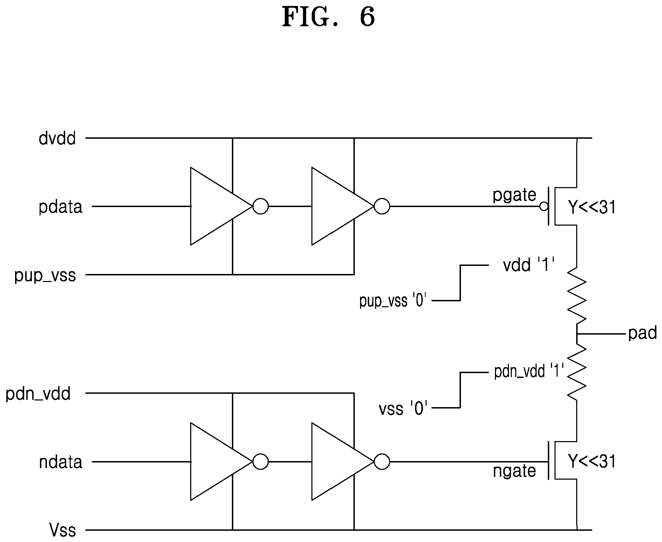

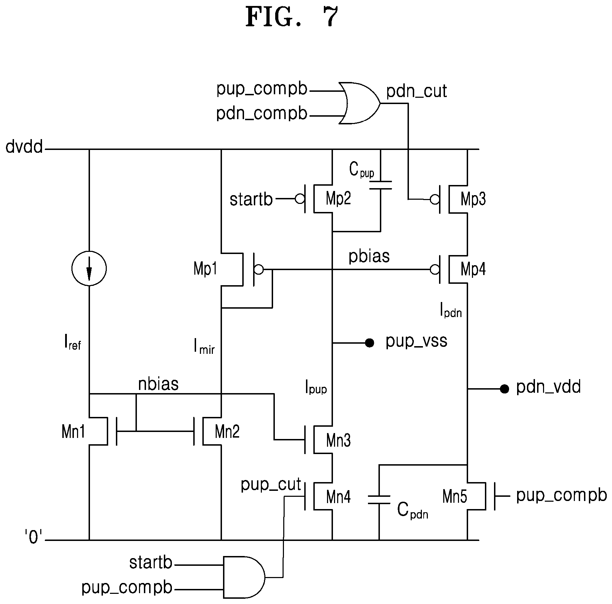

The circuit shown in FIG. 7 can be configured to set the driver impedance by varying the gate voltage of the PMOS circuit (i.e., the pull up driver) and the NMOS circuit (i.e., the pull down driver). The circuit can set the pull up driver impedance and the pull-down driver impedance by varying the first variable voltage and the second variable voltage respectively. The circuit shown in FIG. 7 can use the first variable voltage/pull up gate voltage as an elevated ground voltage for the pre-driver (i.e., as shown in FIG. 6). The circuit can use the second voltage/pull-down gate voltage as reduced supply voltages for the pre-driver. Also, the circuit can limit a gate-to-source voltage of the PMOS and the NMOS driver, as the voltage scales.

For example, in the pull-up calibration scheme, the pup_vss signal shown in FIG. 4 from the programmable Vdd/Vss generator is provided to the PMOS device in the top driver inside the pull-up calibration block. The pup_vss is the first variable voltage. The pull-up calibration block includes a top driver and a comparator. In the pull-up calibration, the NMOS devices in the top driver are disabled by applying '0' voltage to NMOS devices, and the top driver is connected to an external 240Ω ideal resistor. The programmable Vdd/Vss generator will keep varying the pup_vss signal from HIGH to LOW. As this happens, the output comp_top will vary from LOW to HIGH and the comparator will compare comp_top to vref=0.5*dvdd. When comp_top becomes equal to vref, a comparator output will switch from HIGH to LOW. This comparator output is used as STOP signal to tell the programmable VDD/VSS generator, to STOP reducing the pup_vss signal. This STOP (comparator output going LOW) signal is provided to the NMOS current source in the programmable VDD/VSS generator. The programmable Vdd/Vss generator will LOCK the pup_vss signal, when the STOP signal from the comparator is received.

For example, in the pull down calibration scheme, the pdn_vdd signal shown in FIG. 4 from the programmable Vdd/Vss generator is provided to the NMOS device in the bottom driver inside the pull-down calibration block. The pdn_vdd is the second variable voltage. The locked pup_vss, generated as discussed above, is provided as the input to the PMOS device in the bottom driver. The PMOS device along with the resistor R acts as 240Ω reference for pulldown NMOS calibration. The programmable Vdd/Vss generator continues to vary pdn_vdd signal from LOW to HIGH, causing the output comp_bot to vary from HIGH to LOW. The comparator compares comp_bot to vref=0.5*dvdd. When comp_bot becomes equal to vref, the comparator output will switch from LOW to HIGH. This comparator output is used as a STOP signal to tell the programmable VDD/VSS generator, to STOP increasing the pdn_vdd signal. The STOP (comparator output going HIGH) signal is provided to the PMOS current source in the programmable Vdd/Vss generator. Programmable Vdd/Vss generator will LOCK the pdn_vdd signal, when the STOP signal is received from the comparator. This pull-up and pull-down calibration operation may be performed for every process, voltage, temperature (PVT) corner. Thus, for every PVT corner, the pup_vss voltage and the pdn_vdd voltage may be determined through the analog calibration scheme described above.

As used herein, the terms 'first variable voltage', 'pup_vss', and 'pull-up gate voltage' can be interchangeably used. Also, the terms 'second variable voltage', 'pdn_vdd', and 'pull-down gate voltage' can be used interchangeably.

As used herein, the terms 'driver output', 'first driver output' of the pull-up calibration are referred to herein as Vₚᵤₚ. Also, the terms 'driver output', 'second driver output' used in the pull-down calibration are referred to herein as V_{pdn}.

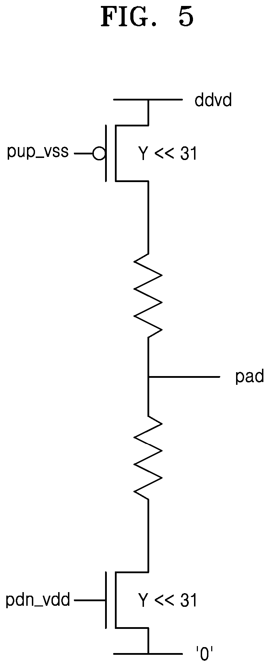

FIG. 5 depicts a driver structure with fixed legs used in a calibration scheme, according to example embodiments. As illustrated in FIG. 5, the driver structure can be configured with a fixed number of legs. The pull up gate voltage pup_vss and the pull-down gate voltage pdn_vdd can be varied to set pull-up and pull-down driver impedance. The pull up gate voltage pup_vss can be used as an elevated ground voltage. The pdn_vdd can be used as a reduced supply voltage for the pre-driver.

FIG. 6 is an example circuit diagram illustrating the usage of voltage generators in pre-driver structure, i.e., voltages provided by generation circuits being used in pre-driver structure, according to example embodiments. As illustrated in FIG. 6, a variable gate voltage generation circuit block, a pull-up stop signal generation circuit block and a pull-down stop signal generation circuit block can be used for generating pup_vss, and pdn_vdd. The variable gate voltage generation circuit block can be configured with a supply voltage dvdd and a ground voltage (Vss). dvdd is the voltage applied to the source of the PMOS transistor. dvdd is the positive power voltage. Vss is the voltage applied to a source of the NMOS transistor. Vss is less than dvdd. Vss may be a negative power voltage or connected to ground.

As shown in FIG. 4, the pull-up gate voltage generated by the variable gate voltage generation circuit 402 can be provided to the PMOS driver. On receiving the pull-up gate voltage, a transistor of the PMOS driver with a power supply, can generate a first driver output connected to an external resistor.

On identifying that the first generated driver output is greater than a reference value (Vref), the pull-up stop signal generation circuit 404 can generate a stop signal. The generated stop signal can be used to stop the receiving first variable voltage (pup_vss) (i.e., stop the first variable voltage from changing) using the calibration stop signal pup_compb.

On identifying that the second generated driver output from the NMOS driver is less than the reference value (Vref), the pull-down stop signal generation circuit 406 can generate a stop signal. The generated stop signal can stop the receiving pull down gate voltage (i.e., stop the second variable voltage or pull down gate voltage from changing) using the pull-down calibration stop signal pdn_compb.

The pull-up gate voltage (pup_vss) and the pull-down gate voltage (pdn_vdd) can be configured to slowly charge and discharge a capacitor for generating the voltages. Two biases are generated, such as pbias and nbias for sourcing and sinking I_{pdn} and Iₚᵤₚ respectively. As illustrated, the pull-up gate voltage (pup_vss) and the pull-down gate voltage (pdn_vdd) work sequentially. The pull up gate voltage (pup_vss) can be generated, followed by the pull-down gate voltage (pdn_vdd).

FIG. 7 is an example circuit diagram illustrating a programmable voltage generation circuit used in pull-up and pull-down calibration schemes. For example, the circuit diagram shown in FIG. 7 may correspond to the variable gate voltage generation circuit 402 shown in FIG. 4. The pull up gate voltage (pup_vss) can be generated by initiating the PMOS driver by setting the startb gate to 'zero', and by charging the capacitor Cₚᵤₚ to dvdd through transistor Mp2. Further, when startb is 'one' and the pup_compb is 'one', pup_cut is set to 'one', and Iₚᵤₚ current is sunk through transistors Mn3 and Mn4. This leads to a reduction in pup_vss. When pup_compb is 'zero', pull up generation is stopped, hence pup_cut becoming 'zero', stopping the current drawn through transistor Mn3, and locking the pup_vss voltage.

The pull-down gate voltage (pdn_vdd) can be generated, after generating pull-up gate voltage (pup_vss) is completed. When pup_compb is set to 'one', capacitor C_{pdn} is discharged to 'zero' through transistor Mn5. Further, as long as pup_compb is 'zero' and pdn_compb is 'zero', pdn_cut is 'zero', I_{pdn} current is drawn through transistors Mp3 and Mp4, and leading to an increase in pdn_vdd. When pdn_compb is 'one', pull down generation stops, wherein pup_cut is set to 'one', the current drawn is stopped through transistor Mp3, and pdn_vdd voltage is locked. For example, the current source, transistors Mp2, Mn1 and Mn2 may be collectively referred to as a bias generation circuit.

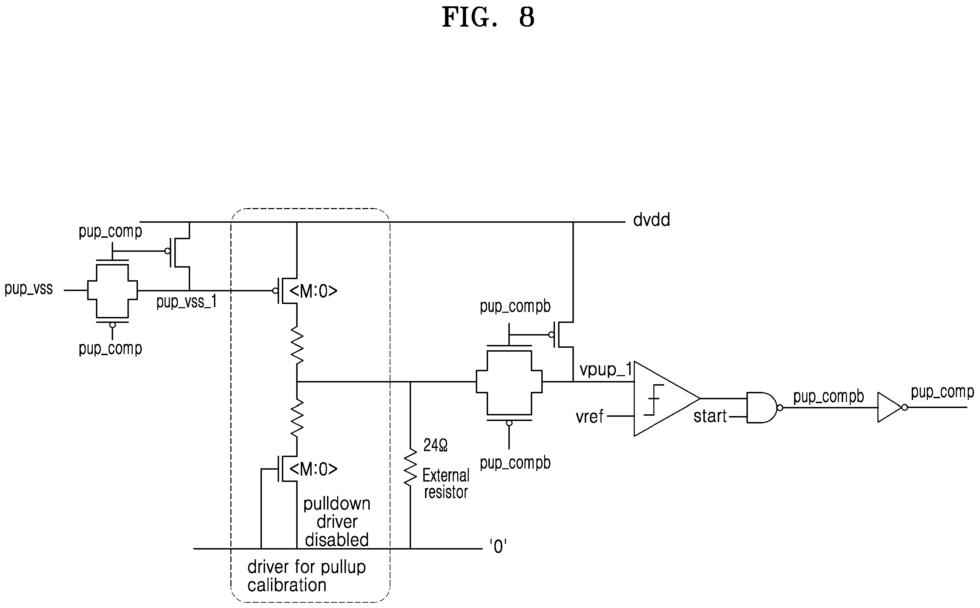

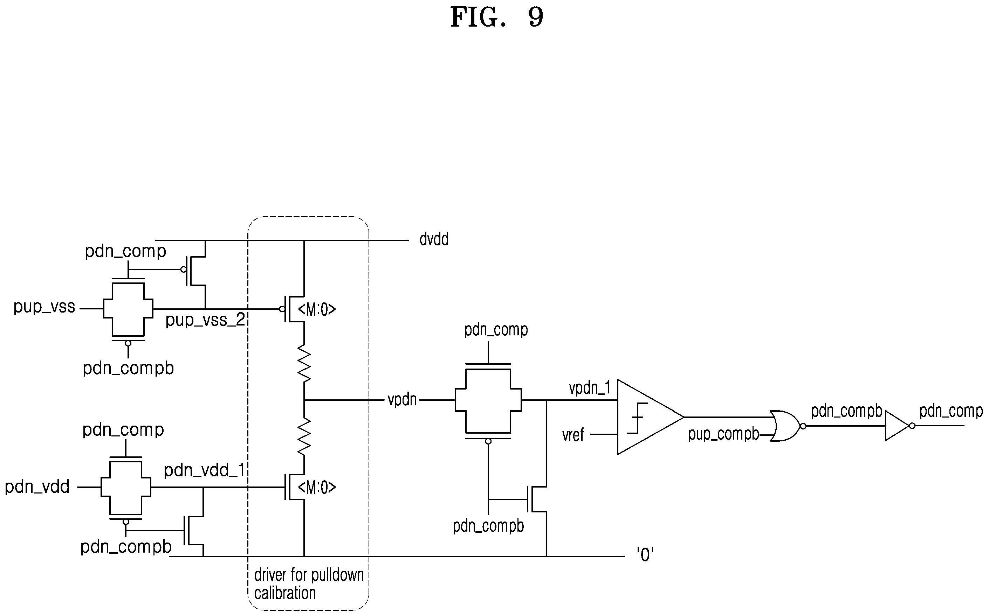

FIGs. 8 and 9 are example circuit diagrams illustrating generating a pull-up calibration stop signal and generating a pull-down calibration stop signal, respectively. FIG. 8 illustrates a circuit for generating the pull up calibration stop signal in the PMOS driver. As illustrated, the pull-up gate voltage (pup_vss) from the pull-up voltage gate generation circuit (pup_vss) (e.g., a portion of the variable gate voltage generation circuit 402) can be configured to the PMOS gate driver, during which the pull down NMOS driver is disabled. As illustrated, the driver output can be connected to an external 240 Ω resistor. In other words, the PMOS driver is connected to an external 240 Ω resistor. The driver output Vₚᵤₚ can be compared to a reference value (V_{ref}), which is 0.5*dvdd. As the pull-up gate voltage pup_vss decreases, the driver output Vₚᵤₚ increases. Also, when the Vₚᵤₚ is greater than 0.5*dvdd (V_{ref}), the comparator output pup _compb switches from one to zero. When the pull up calibration stop signal switches from one to zero, the pull up generation signal pup_vss is locked in the pup_vss generation circuit block.

FIG. 9 illustrates a circuit generating the pull-down calibration stop signal in the NMOS driver. As illustrated, the pull-down gate voltage (pdn_vdd) from the pull-down gate voltage generation circuit (pdn_vdd) (e.g., a portion of the variable gate voltage generation circuit 402) can be configured to the NMOS gate driver. After the pull up calibration, the final value of the pup_vss can be connected to the PMOS driver. The driver output V_{pdn} can be compared to the reference value (V_{ref}) of V_{ref} = 0.5*dvdd. As the pull-down-gate voltage pdn_vdd voltage is increased, the driver output V_{pdn} decreases. When V_{pdn} is less than 0.5*dvdd (V_{ref}), the comparator output pdn_compb switches from zero to one. When the pull-down calibration stop signal switches from zero to one, the pull-down generation signal pdn_vdd is locked on the pdn_vdd generation block. As shown in FIG. 9, during pull-up calibration process, the pull-down calibration is disabled using the signal pup_compb. During pull-up calibration, the signal pup_compb is given as input to the final NOR gate. As long as pup_compb=1, the output of NOR gate will not change, and pull-down calibration is disabled. Thus, pull-down calibration is started sequentially, only after pull-up calibration is completed.

In an example embodiment, the calibration scheme can generate a programmable gate voltage to set the driver impedance. As voltage scales, the pup _vss/pdn_vdd generation circuit can track supply voltage and correspondingly set a gate voltage. As the voltage scales, the gate-to-source voltage (V_{GS}) of the PMOS and NMOS device can be limited. The calibration scheme can provide reduced device stress, with a reduction in V_{GS}. Hence, the device stress can be controlled.

The calibration scheme can provide a reduced mask cost, by reducing the device stress, and use of thin oxide for higher voltage domain. Example embodiments can lead to the usage of single device for multiple voltage domains.

The calibration scheme can provide a reduced calibration time, by using a simple analog based scheme. Hence, the total calibration time is less than one microsecond, with an improved calibration time of 3X. Therefore, time can be saved, and the saved time may be used for other memory transactions.

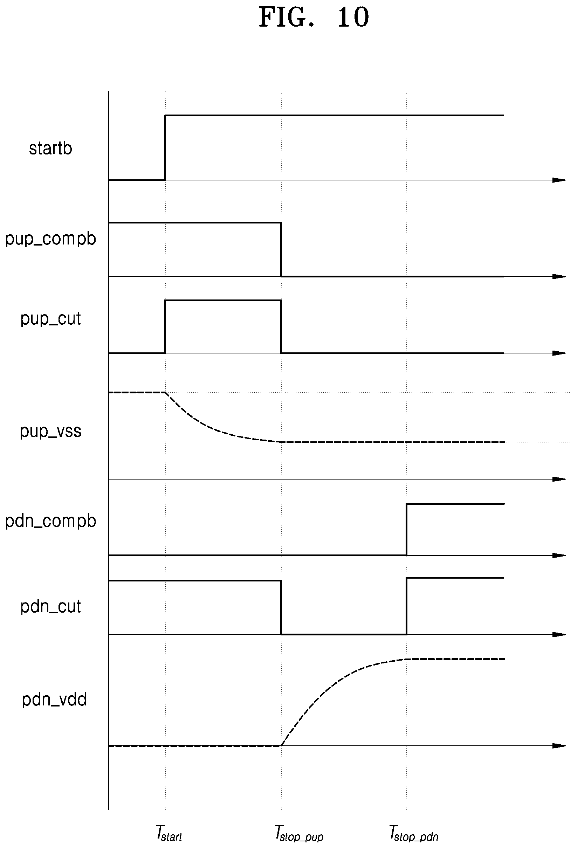

FIG. 10 is an example graph diagram illustrating the programmable voltage generation based on the timing, according to example embodiments. As illustrated, the pull-up gate voltage and pull-down gate voltage can be generated based on the timing. As illustrated, the pull-up calibration can be initiated when startb is set to 'zero' (start is set to 'one' or startb is set to 'zero'). The pull-up calibration stops when pup_comb is zero, and the pull up calibration happens while pup_cut is one.

As illustrated, the pull-up gate voltage (pup_vss) starts from 'dvdd' and performs discharging until pup_cut is one, and stops when pup_cut is zero. The pull down calibration stops, when pdn_compb is one. The pull-down calibration happens while pdn_cut is zero. The pull-down gate voltage (pdn_vdd) starts from zero and starts charging until pdn_cut is zero and stops when pdn_cut is one.

For example, the timing diagram of FIG. 10 shows the sequence of generating pup_vss and pdn_vdd signals. First, when startb=0, pup_vss is charged to HIGH voltage (dvdd). When startb=1, the pull-up calibration logic is enabled, and pull-down calibration logic is disabled. As long as startb=1 AND pup_compb=1, pup_vss will keep reducing. When pup_compb switches to '0', pup_vss is locked to its final value. As long as pup_compb=1, pdn_vdd is discharged to LOW (0) voltage. Then, when pup_compb switches to '0', the pull-down calibration is enabled. As long as pup_compb=0 AND pdn _compb=0, the pdn_vdd keeps increasing. When pdn_compb switches to '1', pdn_vdd is locked to its final value. Thus, pull-up and pull-down calibration may be performed sequentially.

As discussed above, FIG. 7 is an example circuit diagram illustrating a programmable voltage generator generation circuit used in pull-up and pull-down calibration schemes. For example, the circuit shown in FIG. 7 may be used for generating the gate voltages pup_vss and pdn_vdd. The pup_vss and pdn_vdd signals are used as part of the analog calibration scheme discussed above with respect to FIG. 4. The circuit that generates the pup_vss and pdn_vdd signals may be referred to as a programmable Vdd/Vss generator. With reference to FIGS. 7 and 10, the locked pup_vss may be generated. Initially when startb =0, pup_vss is charged to DVDD through Mp2 PMOS transistor. The programmable Vdd/Vss generator circuit keeps sensing the pull-up calibration STOP signal pup_compb. This STOP signal pup_compb is the output of the comparator used in the pull-up calibration block. As long as startb=1 AND pup_compb=1, the NMOS transistor Mn4 is ON and the current source, will 'sink' current (Ipup) and pup_vss will keep reducing. When pup_compb switches to 0, transistor Mn4 is disabled and no current is drawn. Thus, pup_vss will remain locked. Thus using pup_compb as a STOP signal, pup_vss voltage can be stopped from reducing. The locked pdn_vdd may also be generated. Initially when pup_compb=0, the pdn_vdd is discharged to '0' through Mn5 NMOS transistor. The programmable Vdd/Vss generator circuit keeps sensing the pull-down calibration STOP signal pdn_compb. This STOP signal pdn_compb is the output of the comparator used in the pull-down calibration block. As long as pup_compb=0 AND pdn_compb=0, the PMOS transistor Mp3 is ON and the current source, will source current (Ipdn) and pdn_vdd will keep increasing. When pdn_compb switches to 1, transistor Mp3 is disabled and no current is sourced and pdn_vdd will remain locked. Thus, by using pdn_compb as a STOP signal, pdn_vdd voltage can be stopped from increasing.

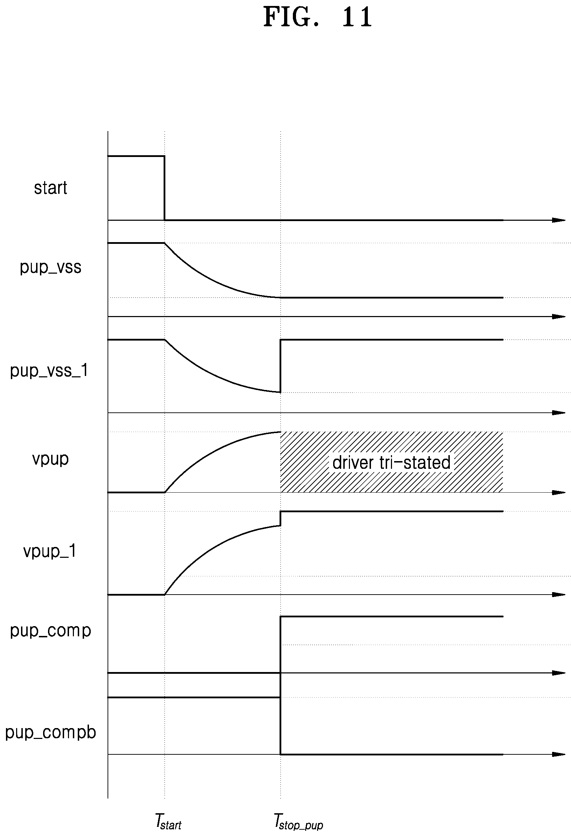

FIG. 11 is an example graph diagram illustrating a pull up calibration stop signal generation based on the timing, according to example embodiments. For generating the pull up calibration stop signal based on the timing, an initial value is dvdd, wherein the calibration begins after Tₛₜₐᵣₜ. The final calibrated value when pull up calibration stops (when pup_comp ='1'). After calibration, pup_vss_1 is pulled to dvdd. During the calibration, pup_vss_1 is pup_vss. Afterwards, the calibration driver is tri-stated and output is undefined, wherein the tri-stated stands for the three states of the driver output and three states are 'zero', 'one', and 'undefined'. When driver is turned off or disabled it will be in undefined state. After calibration, the comparator input vpup_1 is pulled up to dvdd, to avoid false tripping. During calibration, vpup_1 is vpup, comparator output trips from zero to one (when vpup_1 is greater and equal to vref). Hence, the pup_compb in inversion of pup_comp. For example, as shown in FIG. 8, the PMOS driver signal pup_vss_1 is controlled by a pass gate with select signals pup_comp/pup_compb. This is because once the calibration is completed, any noise on the signal pup_vss_1, will change the output voltage Vpup. Any change in Vpup due to noise on pup_vss_1, will affect the comparator output (which should not change once the calibration is done). To avoid this problem, once pull-up calibration process is completed, the driver is tri-stated or disabled by pulling the signal pup_vss_1 to HIGH (dvdd) using a PMOS switch controlled by pup_comp signal. When pull-up calibration is done, pup _compb will be '1' and pup_comp will be '0', pup_vss_1 is disconnected from pup_vss and pulled to HIGH(dvdd). Thus, the driver is disabled. Because the driver is disabled, the driver output Vpup, will be floating. Accordingly, once pull-up calibration is done, the comparator input Vpup_1 is disconnected from Vpup and Vpup_1 is also pulled to HIGH (dvdd). Because Vpup_1=HIGH (dvdd), the value is much higher than vref, and hence comparator output will not change. This avoids any change in the comparator output, once pull-up calibration is done.

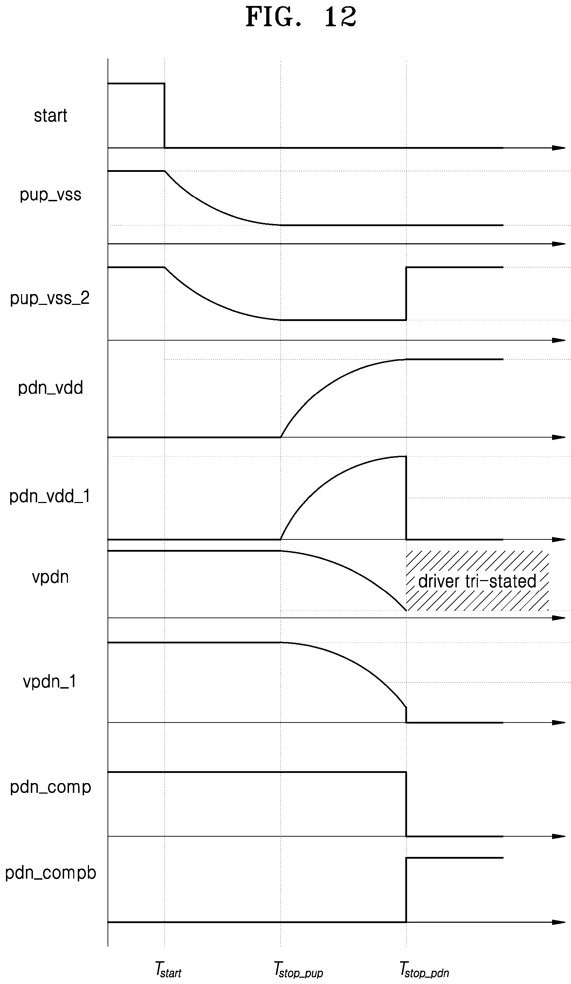

FIG. 12 is an example graph diagram illustrating a pull-down calibration stop signal generation based on the timing, according to example embodiments. For generating the pull-down calibration stop signal, the calibrated value of 240 Ω is set for the pull-up driver. After performing pull-down calibration, pup_vss_2 is pulled to dvdd to tri-state driver. During the calibration, pup_vss_2 is equal to pup_vss. The final calibrated value is the value, when the pull-down calibration stops (when pdn_comp=0). The initial value is '0', wherein calibration begins after T_{stop_pup}. During the calibration, pdn_vdd_1 is equal to pdn_vdd. After pulldown calibration, pdn_vdd is pulled to zero to tri-state driver. After calibration, the driver is tri-stated and the output is undefined. During calibration, vpdn_1 is equal to vpdn. After calibration, the comparator input vpdn_1 is pulled down to zero to avoid false tripping. The comparator output trips from 'one' to 'zero', when vpdn_1 is lesser and equal to vref. pdn_compb is the inversion of pdn_comp.

Example embodiments disclosed herein describes circuits for performing analog calibration for a scalable multi-voltage memory interface driver. It is understood example embodiments include a computer readable storage medium having stored thereon program code for implementation of one or more operations of the method, when the program runs on a server or mobile device or any suitable programmable device. The method is implemented in at least one example embodiment through or together with a software program written in e.g., Very high speed integrated circuit Hardware Description Language (VHDL) another programming language, or implemented by one or more VHDL or several software modules being executed on at least one hardware device. The hardware device can be any kind of portable device that can be programmed. The device may also include means which could be e.g., hardware means like e.g., an ASIC, or a combination of hardware and software means, e.g., an ASIC and an FPGA, or at least one microprocessor and at least one memory with software modules located therein. The method example embodiments described herein could be implemented partly in hardware and partly in software. Alternatively, the invention may be implemented on different hardware devices, e.g., using a plurality of CPUs.

While aspects of example embodiments have been particularly shown and described, it will be understood that various changes in form and details may be made therein without departing from the scope of the following claims.

## Claims

1. A circuit for calibrating analog signals on a scalable memory interface driver, the circuit comprising:
a p-channel metal-oxide semiconductor (PMOS) driver;
an n-channel metal-oxide semiconductor (NMOS) driver;
a variable gate voltage generation circuit;
a pull-up stop signal generation circuit; and
a pull-down stop signal generation circuit;
wherein the circuit is configured to:
provide a first variable voltage to the PMOS driver from the variable gate voltage generation circuit, wherein a transistor of the PMOS driver is configured to receive a power supply voltage, and a first driver output of the PMOS driver is connected to an external resistor;
stop the first variable voltage from changing by disconnecting a first current source according to a pull-up calibration stop signal, based on identifying that the first driver output is greater than a reference value;
provide a second variable voltage to the NMOS driver from the variable gate voltage generation circuit, wherein a second driver output from the NMOS driver is provided after the pull-up calibration stop signal is generated; and
stop the second variable voltage from changing by disconnecting a second current source according to using a pull-down calibration stop signal, based on the second driver output from the NMOS driver being less than the reference value.

2. The circuit as claimed in claim 1, further comprising a comparator,
wherein the circuit is further configured to:
switch an output of the comparator from one to zero, based on the first driver output being greater than the reference value, wherein the reference value is a reference voltage provided to the comparator; and
lock a pull-up generation signal in a pull-up voltage generation circuit, based on the pull-up calibration stop signal switching from one to zero.

3. The circuit as claimed in claim 1, further comprising a comparator and a pull-down signal generation circuit,
wherein the circuit is further configured to, based on a driver output being less than the reference value, switch an output of the comparator from zero to one, and based on the pull-down calibration stop signal switching from zero to one, lock a pull-down generation signal in the pull-down stop signal generation circuit.

4. The circuit as claimed in any preceding claim, wherein the variable gate voltage generation circuit comprises a current source, a current mirror, at least one metal-oxide semiconductor (MOS) device, and at least one capacitor to generate the first variable voltage, and
wherein the first variable voltage is variable set based on a supply voltage.

5. The circuit as claimed in claim 4, wherein a lower supply voltage generation path and a higher ground voltage generation path are formed along the current source, a bias generation circuit, the current mirror, the at least one MOS device and the at least one capacitor.

6. The circuit as claimed in claim 1, further comprising:
a comparator; and
a calibration stop signal generation circuit configured to use the external resistor and the comparator to generate the pull-up calibration stop signal and the pull-down calibration stop signal based on a comparison of a driver output voltage and a reference voltage, wherein the reference voltage is an input voltage to the comparator.

7. The circuit as claimed in any preceding claim, wherein the circuit is further configured to set a driver impedance by varying the first variable voltage and the second variable voltage.

8. The circuit as claimed in any preceding claim, wherein the circuit is further configured to set a pull-up driver impedance, and a pull-down driver impedance by varying the first variable voltage and the second variable voltage, respectively.

9. The circuit as claimed in any preceding claim, wherein the circuit is further configured to:
use the first variable voltage as an elevated ground voltage; and
use the second variable voltage as a reduced supply voltage.

10. The circuit as claimed in any preceding claim, wherein the circuit is further configured to limit a gate-to-source voltage of the PMOS driver and the NMOS driver.

11. A method for calibrating analog signals on a scalable memory interface driver using a circuit that comprises a p-channel metal-oxide semiconductor (PMOS) driver; an n-channel metal-oxide semiconductor (NMOS) driver; a variable gate voltage generation circuit; a pull-up stop signal generation circuit; and a pull-down stop signal generation circuit, the method comprising:
providing a first variable voltage to the PMOS driver from the variable gate voltage generation circuit;
stopping the first variable voltage from changing by disconnecting a first current source according to using a pull-up calibration stop signal, based on identifying that a first driver output is greater than a reference value;
providing a second variable voltage to the NMOS driver from the variable gate voltage generation circuit, wherein a second driver output from the NMOS driver is provided after the pull-up calibration stop signal is generated; and
stopping the second variable voltage from changing by disconnecting a second current source according to using a pull-down calibration stop signal, based on the second driver output from the NMOS driver being less than the reference value.

12. The method as claimed in claim 11, further comprising:
switching an output of a comparator from one to zero, based on the first driver output being greater than the reference value, wherein the reference value is a reference voltage provided to the comparator; and
locking a pull-up generation signal in a pull-up voltage generation circuit, based on the pull-up calibration stop signal switching from one to zero.

13. The method as claimed in claim 11, further comprising:
based on a driver output being less than the reference value, switching an output of a comparator from zero to one; and
based on the pull-down calibration stop signal switching from zero to one, locking a pull-down generation signal in the pull-down stop signal generation circuit.

14. The method as claimed in any of claims 11 to 13, further comprising setting the first variable voltage based on a supply voltage.

15. The method as claimed in claim 14, forming a lower supply voltage generation path and a higher ground voltage generation path along a current source, a bias generation circuit, a current mirror, at least one MOS device and at least one capacitor.
